# EUROPEAN PATENT APPLICATION

(11) **EP 2 851 954 A1**
(43) Date of publication of application: **25.03.2015**
(21) Application number: 14184052.0
(22) Date of filing: 09.09.2014
(51) Int. Cl.: H01L 27/146

(54) **Radiation detector and radiation detection apparatus**

(30) Priority: 20.09.2013 JP 2013195677
(71) Applicant: Kabushiki Kaisha Toshiba, Tokyo 105-8001 (JP)
(72) Inventor: Yagi, Hitoshi, Tokyo (JP); Hasegawa, Rei, Tokyo (JP); Atsuta, Masaki, Tokyo (JP); Hosono, Yasuharu, Tokyo (JP); Sasaki, Keita, Tokyo (JP); Kawata, Go, Tokyo (JP)
(74) Representative: Hoffmann Eitle

(57) **Abstract**

A radiation detector according to an embodiment includes: a semiconductor substrate; a light detecting unit provided on a side of a first surface of the semiconductor substrate; a first insulating film provided covering the light detecting unit; a second insulating film covering the first insulating film; a scintillator provided on the second insulating film; an interconnection provided between the first and second insulating films, and connected to the light detecting unit; a first electrode connected to the interconnection through a bottom portion of the first opening; a second electrode provided on a region in the second surface of the semiconductor substrate, the region opposing at least a part of the light detecting unit; a second opening provided in a region surrounding the first electrode and not surrounding the second electrode; and an insulating resin layer covering the first and second electrodes and the first and second openings.

## Description

### FIELD

Embodiments described herein relate generally to radiation detectors and radiation detection apparatuses.

### BACKGROUND

In a radiation imaging system such as a radiography apparatus or a computerized tomography (CT) system, X-ray beams from an X-ray source are emitted to a test subject or an object such as a patient or baggage. An X-ray beam attenuates as passing through a test subject, and then enters a radiation detector. As detecting pixels are arranged in an array in a radiation detector, an X-ray that has entered the radiation detector enters the detecting pixels arranged in an array. The intensity of radiation to be detected by each detecting pixel normally depends on X-ray attenuance. The respective detecting elements of the detecting pixels arranged in an array generate electrical signals corresponding to attenuated X-ray beams sensed by the respective detecting elements independently of one another. These signals are transmitted to a data processing system for analysis, and an image is eventually formed by the data processing system.

### BRIEF DESCRIPTION OF THE DRAWINGS

Fig. 1 is a cross-sectional view showing a radiation detector according to a first embodiment;
Fig. 2 is a plan view showing one pixel of the radiation detector of the first embodiment;
Fig. 3 is a plan view showing the pixel array of the radiation detector of the first embodiment;
Fig. 4 is a cross-sectional view showing a radiation detector according to a first modification of the first embodiment;
Fig. 5 is a cross-sectional view showing a radiation detector according to a second modification of the first embodiment;
Figs. 6(a) through 6(c) are cross-sectional views showing the process of manufacturing the radiation detector of the first embodiment;
Figs. 7(a) through 7(c) are cross-sectional views showing the process of manufacturing the radiation detector of the first embodiment;
Figs. 8(a) through 8(c) are cross-sectional views showing the process of manufacturing the radiation detector of the first embodiment;
Fig. 9 is a cross-sectional view showing a radiation detector according to a second embodiment;
Fig. 10 is a cross-sectional view showing a radiation detector according to a third embodiment;
Figs. 11(a) and 11(b) are cross-sectional views showing the process of manufacturing the radiation detector of the third embodiment; and
Figs. 12(a) through 12(c) are diagrams for explaining a radiation detection apparatus according to a fourth embodiment.

### DETAILED DESCRIPTION

A radiation detector according to an embodiment includes: a semiconductor substrate having a first surface and a second surface located on the opposite side from the first surface; a light detecting unit provided on a side of the first surface of the semiconductor substrate; a first insulating film provided on the first surface to cover the light detecting unit; a second insulating film covering the first insulating film; a scintillator provided on the second insulating film, and converting radiation into visible light; a first opening penetrating through the semiconductor substrate and the first insulating film; an interconnection provided between the first insulating film and the second insulating film, and connected to the light detecting unit; a first electrode connected to the interconnection through a bottom portion of the first opening, the first electrode being provided on a bottom surface and a side surface of the first opening and on part of the second surface; a second electrode provided on a region in the second surface of the semiconductor substrate, the region opposing at least a part of the light detecting unit; a second opening provided in the semiconductor substrate, the second opening being located in a region, the region surrounding the first electrode and not surrounding the second electrode; and an insulating resin layer covering the first electrode, the second electrode, the first opening, and the second opening, the insulating resin layer having a third opening and a fourth opening provided therein, the third opening leading to the first electrode, the fourth opening leading to the second electrode.

Before embodiments of the present invention are described, how the embodiments have been developed is explained.

In a radiation detector of indirect conversion type, visible light that is generated from radiation entering a scintillator is detected by light detecting units such as photodiodes or photomultipliers.

Regarding a radiation detector that includes such a scintillator and pixels with light detecting units arranged in an array, there is a demand for formation of a large number of pixels at a high density so as to obtain high-quality CT images with arrayed pixels. However, it is difficult to extract electrical signals from pixels formed at a high density with interconnections connected by wire bonding. In view of this, through electrodes that are called TSV (Through Silicon Via) electrodes are normally required.

In a case where TSV electrodes are formed on light detecting units, the TSV electrodes are normally formed after the light detecting units are formed in a semiconductor substrate ("via-last"). In a case where the light detecting units are formed in a semiconductor substrate after the TSV electrodes are formed ("via-first"), the material of the TSV electrodes needs to be capable of tolerating various kinds of load (such as heat history) during the light detecting unit manufacturing process, and therefore, the material of the TSV electrodes is limited.

By a general method of manufacturing the TSV electrodes, through holes for forming the TSV electrodes are formed in the semiconductor substrate having the light detecting units formed therein, and insulating layers for insulating and isolating the TSV electrodes from the semiconductor substrate are formed. After that, the TSV electrodes are completed by using a plating technique or the like. At this point, the breakdown voltage of the insulating films (hereinafter also referred to as TSV insulating films) formed on the side walls of the through holes is important. Particularly, in the case of an avalanche photodiode (hereinafter also referred to as an APD) that operates in Geiger mode, a relatively high voltage of approximately 20 V to 80 V is applied between the cathode electrode and the anode electrode of the APD for driving. Therefore, the TSV insulating film for the APD needs to have a sufficiently high breakdown voltage. That is, in a case where TSV electrodes are formed on APDs, it is necessary to pay enough attention to the breakdown voltage of the TSV insulating films.

So as to improve the breakdown voltage of TSV insulating films, the inventors have considered the following aspects.

In a case where TSV electrodes are formed, it is difficult to form the openings for through holes if the semiconductor substrate is thick. Therefore, a supporting member is bonded to the substrate with an adhesive agent, and the substrate is thinned by polishing. After that, the openings for through holes are formed. Therefore, in a case where TSV insulating films are formed, it is necessary to pay attention to the heat resistance of the adhesive agent. For example, in a case where TSV insulating films are formed by plasma CVD (Chemical Vapor Deposition), by which insulating films can be formed at relatively low temperatures, film quality and breakdown voltage become lower than those of thermally-oxidized films or CVD films formed by high-temperature plasma, if SiO₂ films are formed at a low temperature such as 200°C, for example, by taking into account the heat resistance of the adhesive agent. Particularly, the CVD gas flow becomes slower at the bottom portions of the through holes than in the substrate surface, and therefore, degradation in the insulating film quality is conspicuous at the bottom portions. In a case where the TSV insulating films are made of a resin material, contact plugs are formed at the bottom portions of the through holes after the insulating films made of resin are formed, and the TSV electrodes are then formed. In this case, the insulating films made of resin deteriorate during the process of forming the contact plugs and the TSV electrodes, and the breakdown voltage of the TSV insulating films becomes lower.

To improve the breakdown voltage of TSV insulating films, isolation trenches that penetrate through a silicon substrate and surround respective TSV electrodes are formed, and insulating films are formed in the isolation trenches before devices and the TSV electrodes are formed in the silicon substrate. By this manufacturing method, Si-based insulating films are formed in the isolation trenches in the following manner. That is, after the isolation trenches are formed, polysilicon films are formed on the inner walls of the isolation trenches, and the polysilicon films are modified into SiO₂ films by thermal oxidation. In voids in the SiO₂ films, SiO₂ films are further formed by CVD. In this case, the type of the insulating films to be formed in the isolation trenches is selected by taking into account various kinds of load (such as heat history) of the device forming process and the through electrode forming process that follow the isolation trench forming process.

By using such a manufacturing method, the TSV insulating films still need to have sufficiently high heat resistance, and the options for the material of the insulating films are limited. Although the insulating films in the isolation trenches are Si-based insulating films, the width of each isolation trench needs to be made smaller to avoid voids, and therefore, processing the isolation trenches becomes difficult. Further, since the isolation trenches are filled with Si-based insulating films that are hard but fragile, there is a possibility that the isolation trench portions will crack when the thinned Si substrate is handled. Also, the process of forming the insulating films in the isolation trenches becomes complicated, resulting in higher manufacturing costs.

The inventors have made intensive studies, and have managed to develop radiation detectors and radiation detection apparatuses that are capable of improving the breakdown voltage of the TSV insulating films. Embodiments of the radiation detectors and the radiation detection apparatuses will be described below.

The following is a description of the embodiments, with reference to the accompanying drawings. However, it should be understood that the drawings are merely schematic, and the relationship between the thickness and the planar size of each component, and the width ratios between layers differ from those in reality. Therefore, specific thicknesses and sizes should be determined by taking into account the description below. Also, the relationships and ratios between components might vary among the drawings.

### (First Embodiment)

A radiation detector according to this embodiment includes: a semiconductor substrate that has a first surface and a second surface located on the opposite side from the first surface; a light detecting unit placed on the side of the first surface of the semiconductor substrate; a first insulating film formed on the first surface to cover the light detecting unit; a second insulating film covering the first insulating film; a scintillator that is placed on the second insulating film and converts radiation into visible light; a first opening penetrating through the semiconductor substrate and the first insulating film; an interconnection that is placed between the first insulating film and the second insulating film, and is connected to the light detecting unit; a first electrode that is placed on the bottom surface and the side surface of the first opening and on part of the second surface, and is connected to the interconnection through a bottom portion of the first opening; a second electrode that is placed on the second surface of the semiconductor substrate having the light detecting unit formed therein, with the semiconductor substrate being divided by the first opening; a second opening that is formed in the semiconductor substrate, and is located in a region that surrounds the first electrode and does not surround the second electrode; and an insulating resin layer that covers the first electrode, the second electrode, the first opening, and the second opening in the second surface of the semiconductor substrate, and has a third opening and a fourth opening formed therein, the third opening leading to the first electrode, the fourth opening leading to the second electrode.

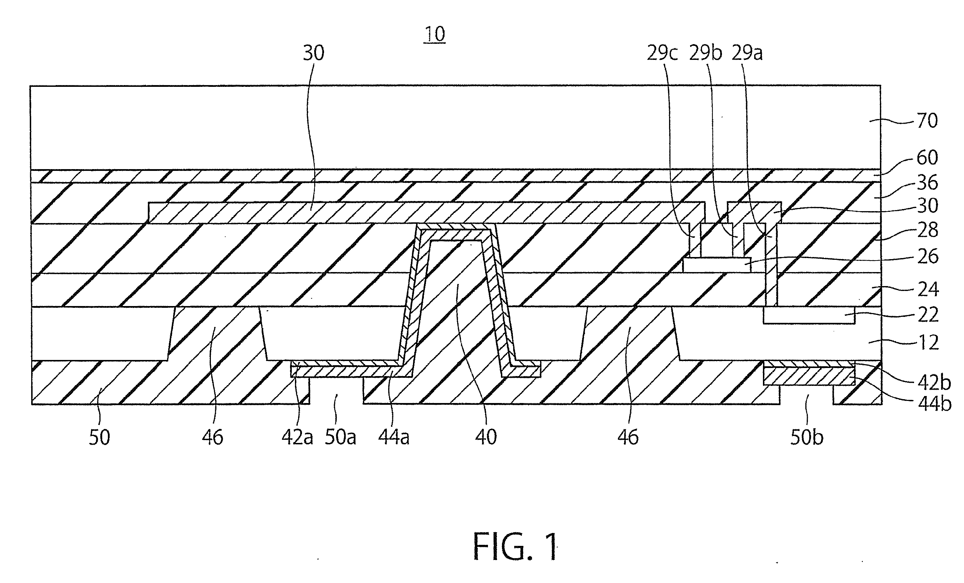

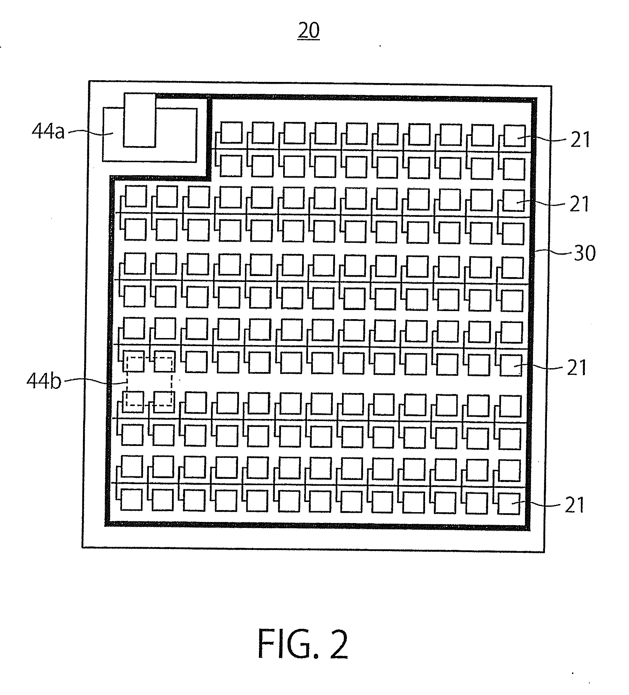

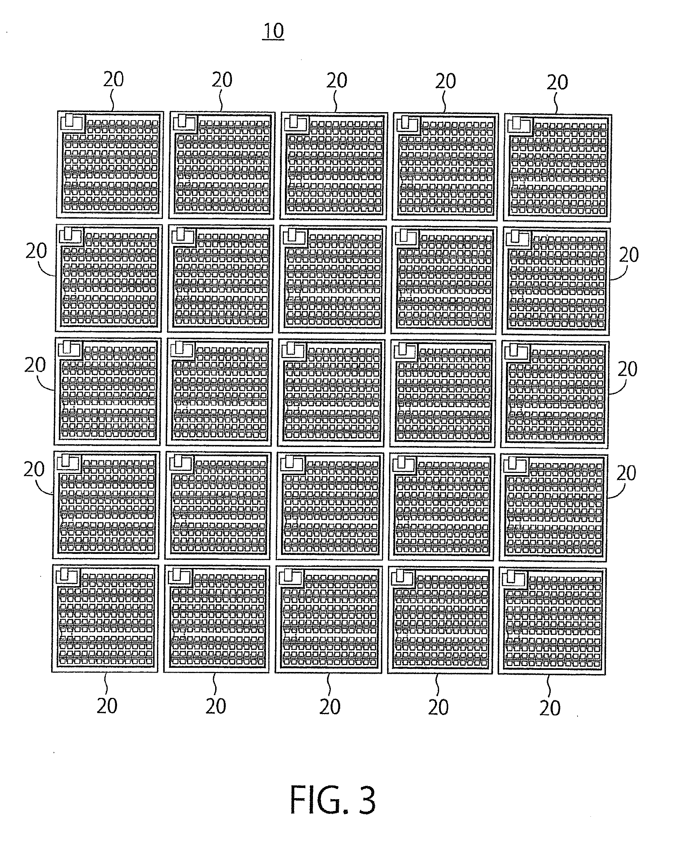

Referring to Figs. 1 through 3, a radiation detector according to a first embodiment is described. As shown in Fig. 3, the radiation detector 10 of the first embodiment includes pixels 20 arranged in a matrix form on a semiconductor substrate (a semiconductor substrate 12 shown in Fig. 1). Fig. 3 shows a 5 x 5 pixel array. As shown in Fig. 2, each pixel 20 includes cells 21, and those cells 21 are connected in parallel by an interconnection 30 made of aluminum, for example. The interconnection 30 is connected to a TSV electrode 44a provided for each pixel 20. A bottom-surface electrode 44b is also provided for each pixel 20. Fig. 1 shows a cross-section of a region surrounding the TSV electrode 44a.

As shown in Fig. 1, the radiation detector 10 of this embodiment includes light detecting units 22 contained in the respective cells 21 in one of the surfaces of the semiconductor substrate 12. The light detecting units 22 are formed with avalanche photodiodes (hereinafter also referred to as APDs). An insulating film 24, made of SiO₂, for example, is placed to cover those light detecting units 22. Resistors 26 made of polysilicon, for example, are placed on the insulating film 24. The resistors 26 are provided for the respective light detecting units 22, and are designed to extract the characteristics of the light detecting units 22. An interlayer insulating film 28 formed with SiO₂ layers is placed to cover the resistors 26. The interconnections 30 are placed on the interlayer insulating film 28. The interconnections 30 are connected to the light detecting units 22 via contacts 29a formed in the interlayer insulating film 28 and the insulating film 24, and are connected to the resistors 26 via contacts 29b and 29c formed in the interlayer insulating film 28. That is, the light detecting units 22 are connected in series to the resistors 26 via the contacts 29a, 29b, and 29c, and the interconnections 30. An insulating film 36 made of SiO₂, for example, is placed to cover the interconnections 30. A scintillator 70 that converts X-rays into visible light is placed on the insulating film 36 via an adhesive agent 60.

Through holes 40 that lead to the interconnections 30 are formed in the surface (the bottom surface) of the semiconductor substrate 12 on the opposite side from the surface having the light detecting units 22 formed therein. The through holes 40 are provided for the respective pixels 20 in one-to-one correspondence. In each of the through holes 40, a seed layer 42a that has a stack structure formed with conductive materials such as a Ti layer and a Cu layer is provided to cover the bottom surface and the side surface of the through hole 40, and to extend onto the bottom surface of the semiconductor substrate 12. The Ti layer is a barrier metal. The electrodes 44a made of Cu, for example, are provided to cover the seed layers 42, so that the electrodes 44a serve as the TSV electrodes. Isolation trenches 46 are formed in the semiconductor substrate 12 so as to surround the respective through holes 40. The isolation trenches 46 are designed to penetrate through the semiconductor substrate 12, and reach the insulating film 24 in Fig. 1. With the isolation trenches 46, the TSV electrode 44a of each pixel 20 is isolated from the cells 21 including the light detecting units 22. Seed layers 42b are also formed in regions on the bottom surface of the semiconductor substrate 12 on the outer sides of the respective isolation trenches 46, and electrodes 44b made of Cu, for example, are formed on the seed layers 42b. The electrodes 44b serve as the bottom-surface electrodes. The bottom-surface electrodes 44b are the terminals for applying voltage to the semiconductor substrate 12. An insulating film 50 made of resin is attached to the bottom surface of the semiconductor substrate 12 to cover the TSV electrodes 44a, the bottom-surface electrodes 44b, and the isolation trenches 46. In the insulating film 50, openings 50a leading to the TSV electrodes 44a and openings 50b leading to the bottom-surface electrodes 44f are formed.

In the radiation detector 10 having such a structure, when an X-ray enters the scintillator 70 from above in Fig. 1, the X-ray is converted into visible light by the scintillator 70. The visible light then passes through the adhesive agent 60, the insulating film 36, the insulating film 28, and the insulating film 24, and is detected by the light detecting units 22. The number of photons in the visible light released from the scintillator 70 is proportional to the energy of the radiation entering the scintillator 70. Accordingly, the energy of radiation that has passed through a test subject can be measured by counting the number of photons in visible light released from the scintillator 70. By utilizing this feature in a CT system or the like, a CT image or a color CT image can be obtained through energy discrimination.

In this embodiment, the pixels 20 each having cells 21 that include light detecting units 22 formed with APDs operating in Geiger mode and are arranged in parallel to the corresponding interconnection 30 are arranged in an array. An APD that operates in Geiger mode is a photodiode that generates a current pulse every time a photon enters the APD. In this embodiment, APDs 22 are arranged in parallel to the corresponding interconnection 30 in each pixel 20. Accordingly, the number of photons that each pixel 20 fails to detect can be reduced. As the pixels 20 each having APDs 22 arranged in parallel are arranged in an array, a current pulse having a wave height proportional to the number of APDs that photons have entered can be obtained. By measuring the wave height of this pulse, the number of phones that have entered the radiation detector 10, or the energy of the radiation that has entered the scintillator 70, can be measured.

### (First Modification)

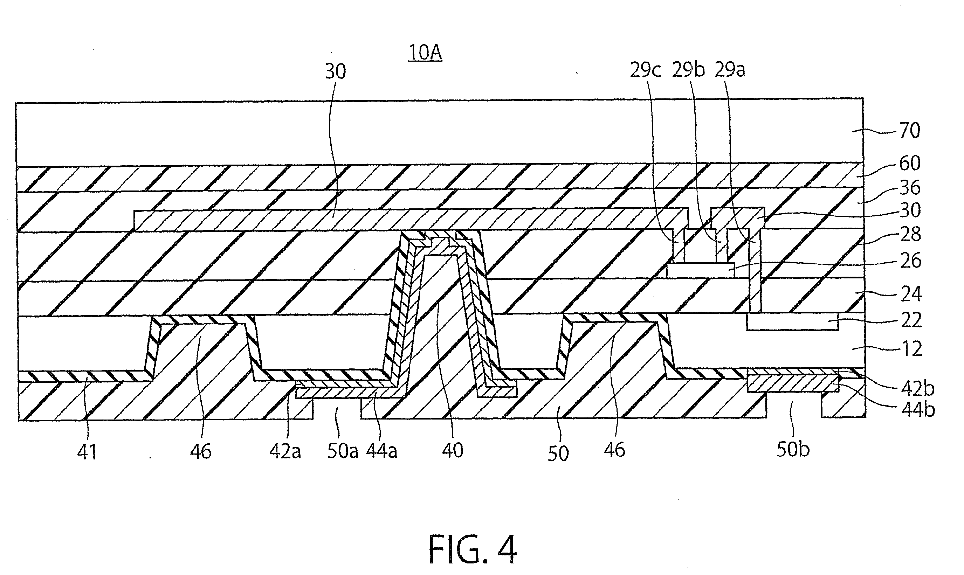

Fig. 4 shows a radiation detector according to a first modification of the first embodiment. The radiation detector 10A of the first modification is the same as the radiation detector 1 of the first embodiment shown in Fig. 1, except that an insulating film 41 that is made of SiO₂ and is formed by CVD (Chemical Vapor Deposition), for example, is further provided to cover the bottom surface of the semiconductor substrate 12 having the through holes 40 and the isolation trenches 46 formed therein, the seed layers 42a and 42b are formed to cover the insulating film 41, and the TSV electrodes 44a and the bottom-surface electrodes 44b are formed on the seed layers 42a and 42b, respectively. Openings corresponding to the bottom surfaces of the through holes 40 are formed in the insulating film 41, and the seed layers 42a are formed to cover the openings.

### (Second Modification)

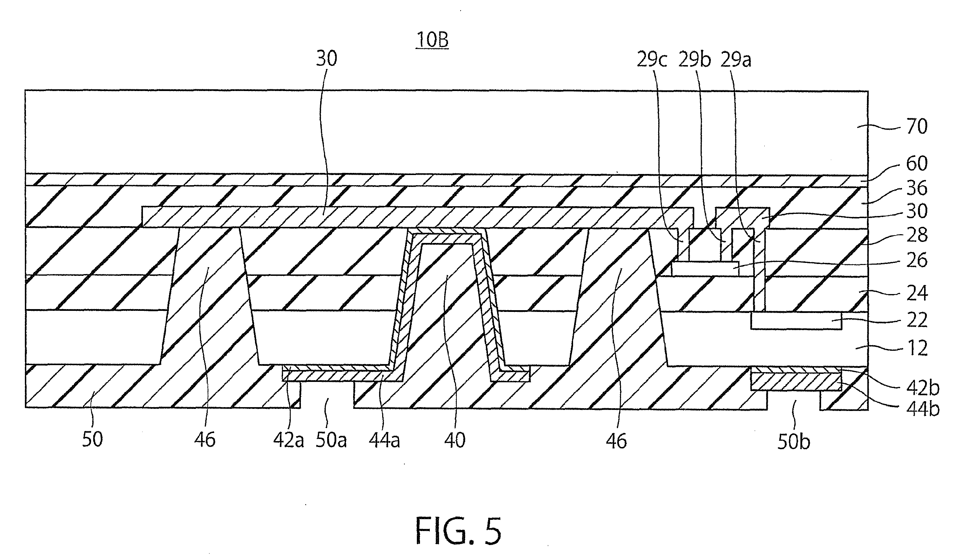

Fig. 5 shows a radiation detector according to a second modification of the first embodiment. The radiation detector 10B of the second modification is the same as the radiation detector 1 of the first embodiment shown in Fig. 1, except that the bottom surfaces of the isolation trenches 46 reach the interconnections 30.

### (Manufacturing Method)

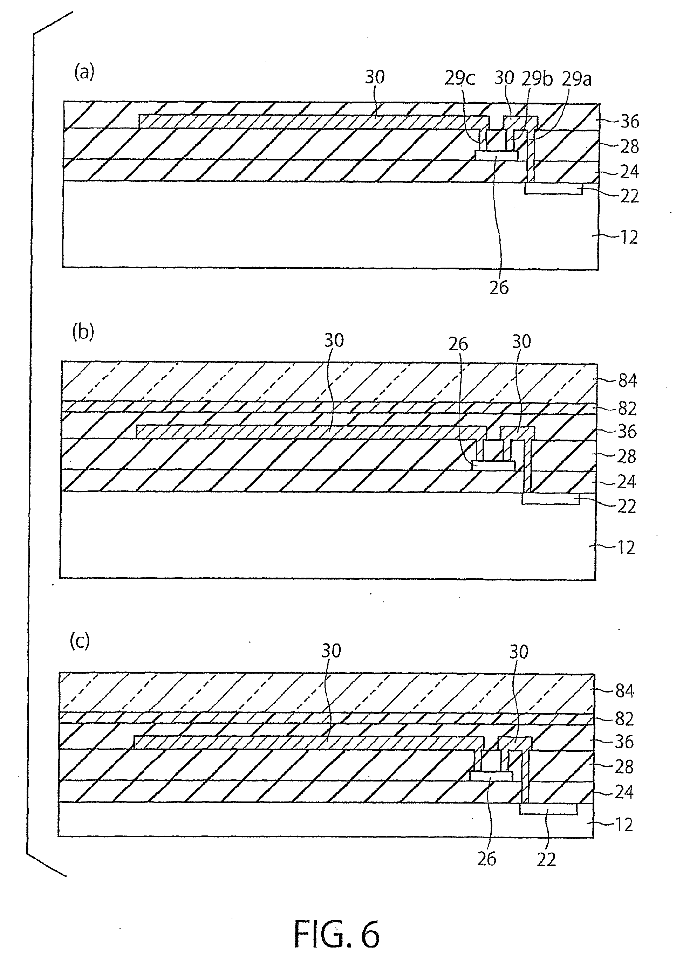

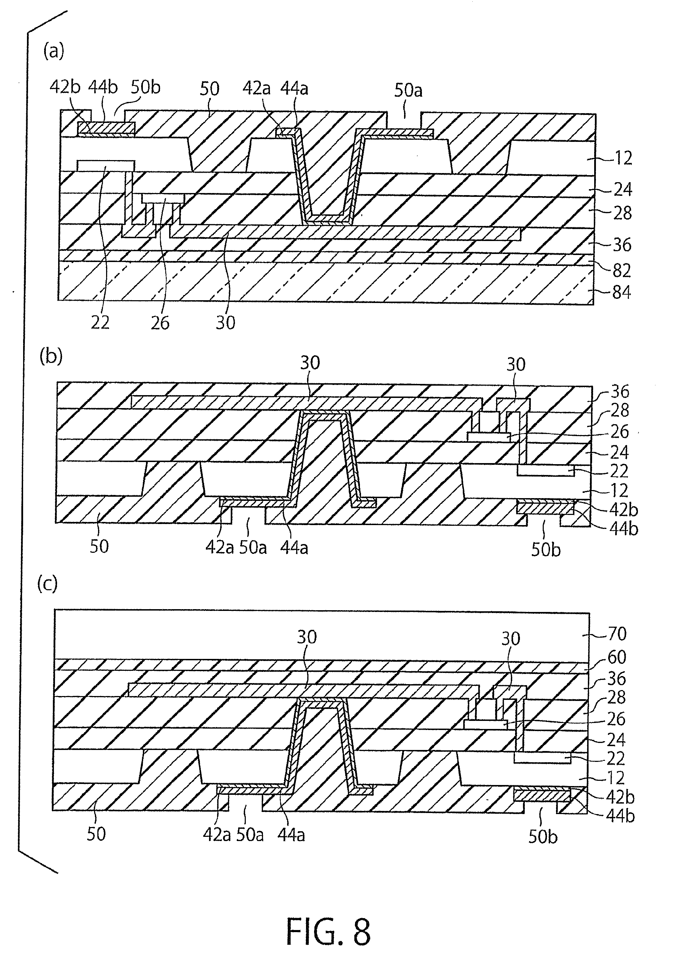

Referring now to Figs. 6(a) through 8(c), a method of manufacturing the radiation detector 10 of the first embodiment is described.

First, as shown in Fig. 6(a), the light detecting units 22 formed with APDs are formed in one of the surfaces of the Si substrate 12. The Si substrate 12 may be a 725-µm thick Si substrate, for example. The insulating film 24 is formed to cover the one surface of the Si substrate 12 in which the light detecting units 22 formed with APDs are formed. The resistors 26 made of polysilicon are formed on the insulating film 24. The interlayer insulating film 28 formed with SiO₂ layers is then formed to cover the resistors 26. Openings leading to the light detecting units 22 and the resistors 26 are formed in the interlayer insulating film 28 and the insulating film 24, and the openings are filled with a conductive material such as aluminum or tungsten, to form the contacts 29a, 29b, and 29c. The interconnections 30 made of aluminum, for example, are then formed on the interlayer insulating film 28, and are connected to the contacts 29a, 29b, and 29c. At this point, the light detecting units 22 are connected in series to the resistors 26 via the contacts 29a, 29b, and 29c, and the interconnections 30. The insulating film 36 made of SiO₂, for example, is then formed on the interlayer insulating film 28 to cover the interconnections 30.

As shown in Fig. 6(b), support glass 84 that is a transparent supporting member and the Si substrate 12 are bonded by using an adhesive agent 82. The thickness of the support glass 84 is 500 µm, for example.

After that, as shown in Fig. 6(c), the Si substrate 12 is polished and thinned to a thickness of approximately 40 µm to 100 µm, with the support glass 84 serving as the supporting member.

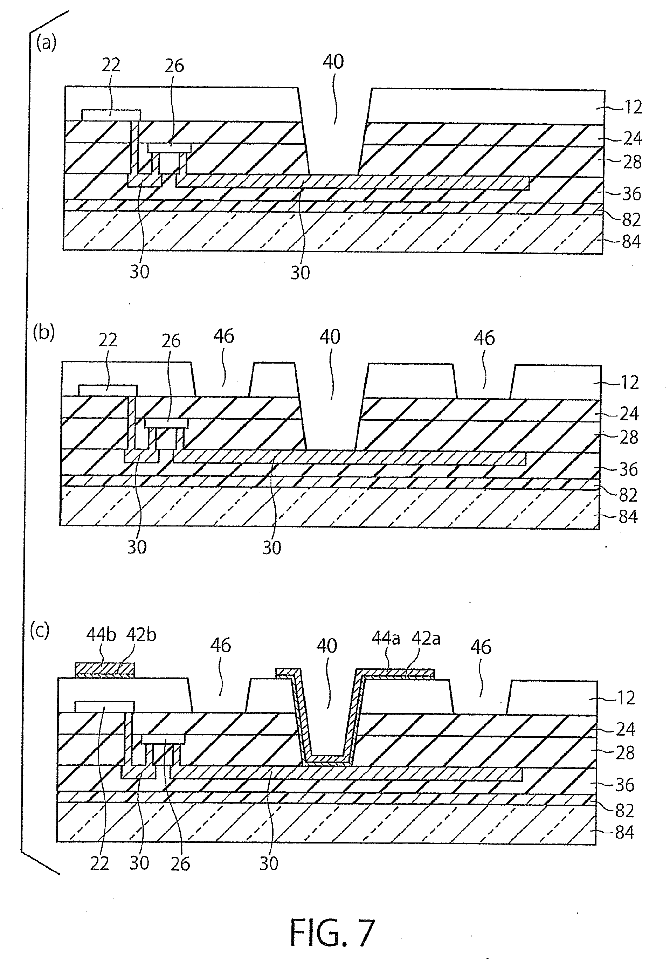

As shown in Fig. 7(a), the positions of the Si substrate 12 and the support glass 84 are reversed. In the positions in the bottom surface of the semiconductor substrate 12 in which the TSV electrodes 44a are to be formed, the through holes 40 are formed by RIE (Reactive Ion Etching). At this point, the bottom portions of the through holes 40 reach the interconnections 30. The interconnections 30 also serve as the etching stopper for the RIE.

As shown in Fig. 7(b), the isolation trenches 46 are formed to surround the respective through holes 40 by RIE. The bottom portions of the isolation trenches 46 penetrate through the Si substrate 12. After penetrating through the Si substrate 12, the isolation trenches 46 may be etched into part of the insulating film 24. Alternatively, the isolation trenches 46 may reach the interconnections 30 like the through holes 40, as in the second modification shown in Fig. 5. The width of each isolation trench 46 (the length in the horizontal direction in the drawing) is 5 µm to 50 µm.

As shown in Fig. 7(c), the seed layers of the stack structure are then formed by stacking a Ti layer and a Cu layer by sputtering, to cover the bottom surfaces and the side surfaces of the respective through holes 40, and the bottom surface of the semiconductor substrate 12. After that, a Cu film, for example, is formed on the seed layers by an electrolytic plating process. Here, the Cu plating is not of a filling type for completely filling the through holes 40, but of a non-filling type (a conformal type). In a later stage, the concave portions of the through holes 40 are filled with the insulating film 50 made of resin. By patterning the seed layers and the Cu film, the seed layers 42a and the TSV electrodes 44a are formed on the bottom surfaces and the side surfaces of the through holes 40, and on part of the bottom surface of the semiconductor substrate 12, and the seed layers 42b and the bottom-surface electrodes 44b are formed in regions on the bottom surface of the semiconductor substrate 12 on the outer sides of the isolation trenches 46.

As shown in Fig. 8(a), the insulating film 50 made of resin is then formed on the bottom surface of the semiconductor substrate 12, to cover the TSV electrodes 44a and the bottom-surface electrodes 44b. The openings 50a and the openings 50b that lead to the TSV electrodes 44a and the bottom-surface electrodes 44b, respectively, are then formed in the insulating film 50. The insulating film 50 may be a photosensitive solder resist, for example. In this case, after a photosensitive solder resist coat is formed, exposure and development are carried out with the use of a predetermined photomask, to form the insulating film 50 having the openings 50a and 50b. Alternatively, the insulating film 50 may be formed with non-photosensitive insulating resin (such as epoxy resin or acrylic resin). In that case, after a non-photosensitive insulating resin coat is formed, a resist mask in a predetermined pattern is formed on the non-photosensitive insulating resin coat. The insulating resin is then patterned by etching, to form the insulating film 50 having the openings 50a and 50b.

After that, as shown in Fig. 8(b), the support glass 84 is detached from the semiconductor substrate 12. At this point, the adhesive agent 82 is also detached from the insulating film 36.

Lastly, as shown in Fig. 8(c), the adhesive agent 60 is applied onto the insulating film 36, and the scintillator 70 and the Si substrate 12 are then bonded. As a result, the radiation detector 10 shown in Fig. 1 is completed. The scintillator 70 may be made of a material such as LGSO ((Lu,Gd)₂SiO₅) or LYSO (Cerium doped Lutetium Yttrium Orthosilicate). The adhesive agent 60 has such a degree of transparency as to transmit visible light generated from the scintillator 70. The thickness of the adhesive agent 60 is approximately 10 µm to 100 µm.

By the above described manufacturing method, the isolation trenches 46 are formed, so that the breakdown voltage of the TSV insulating film 50 or the breakdown voltage between the TSV electrodes 44a and the bottom-surface electrodes 44b can be dramatically improved. Also, as the through holes 40 and the isolation trenches 46 are filled with the insulating resin 50, wafer breakage can be prevented by virtue of the mechanical strength and the appropriate elastic effect of the resin when the thinned Si substrate 12 is handled. If the isolation trenches 46 are made wider to improve the processability of the isolation trenches 46, the isolation trenches 46 can be easily filled with the insulating resin 50. Accordingly, the isolation trenches 46 can be easily processed. Furthermore, as the insulating resin 50 to fill the through holes 40 and the isolation trenches 46 is integrally formed, the manufacturing process can be simplified, and the manufacturing costs can be lowered.

According to the first embodiment and the modifications thereof, a radiation detector that can improve the breakdown voltage of the TSV insulating film can be obtained.

### (Second Embodiment)

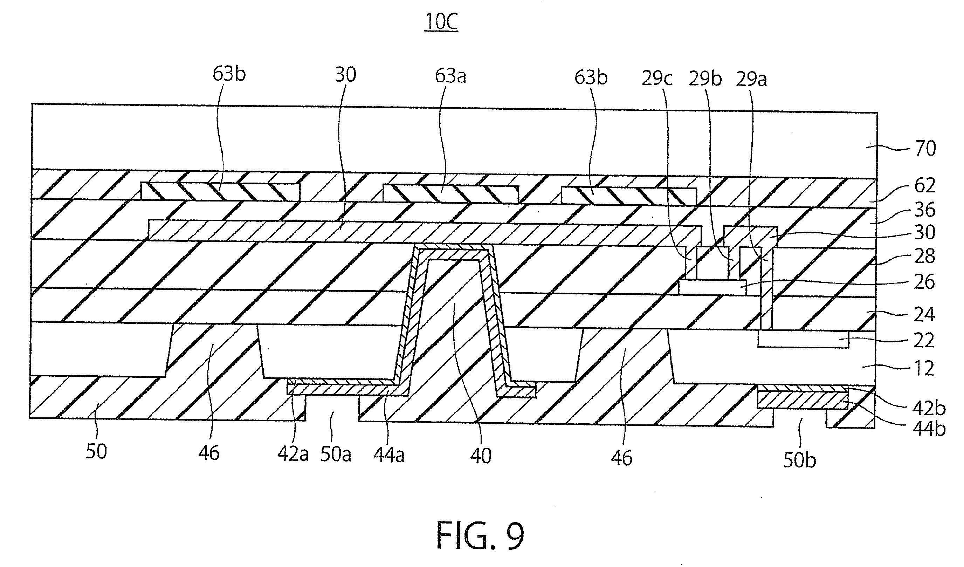

Fig. 9 is a cross-sectional view of a radiation detector according to a second embodiment. The radiation detector 10C of the second embodiment is the same as the radiation detector 10 of the first embodiment shown in Fig. 1, except that insulating layers 63a and 63b made of SiN are formed on the regions of the insulating film 36 corresponding to the regions in which the through holes 40 and the isolation trenches 46 are formed. These insulating layers 63a and 63b can compensate for the decrease in the strength of the Si substrate 12 that is thinned in order to form the through holes 40 and the isolation trenches 46.

This second embodiment can achieve the same effects as those of the first embodiment. The first modification or the second modification of the first embodiment may also be applied to the radiation detector of the second embodiment.

### (Third Embodiment)

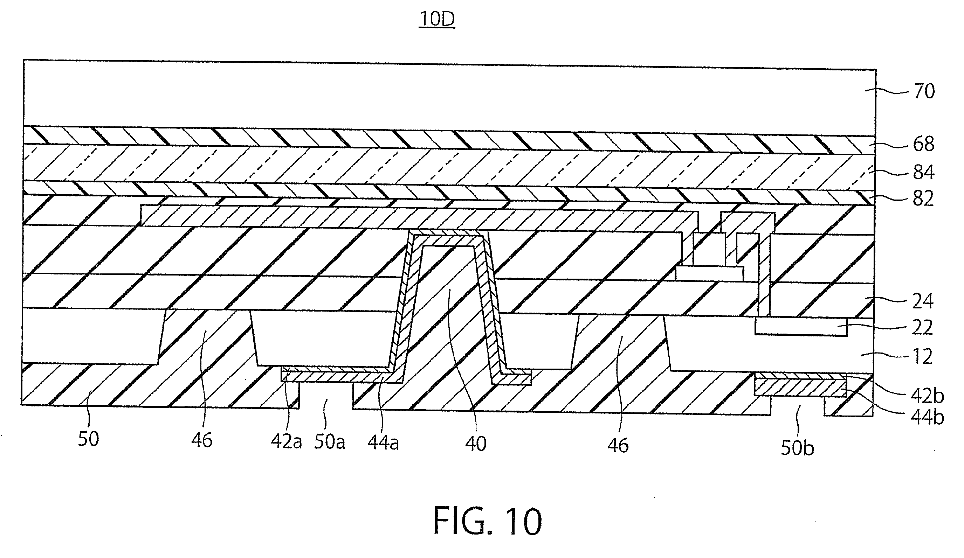

Fig. 10 is a cross-sectional view of a radiation detector according to a third embodiment. The radiation detector 10D of the third embodiment is the same as the radiation detector 10 of the first embodiment shown in Fig. 1, except that the support glass 84 is placed between the insulating film 36 and the scintillator 70, and the support glass 84 is bonded to the insulating film 36 with the adhesive agent 82 and is bonded to the scintillator 70 with an adhesive agent 68.

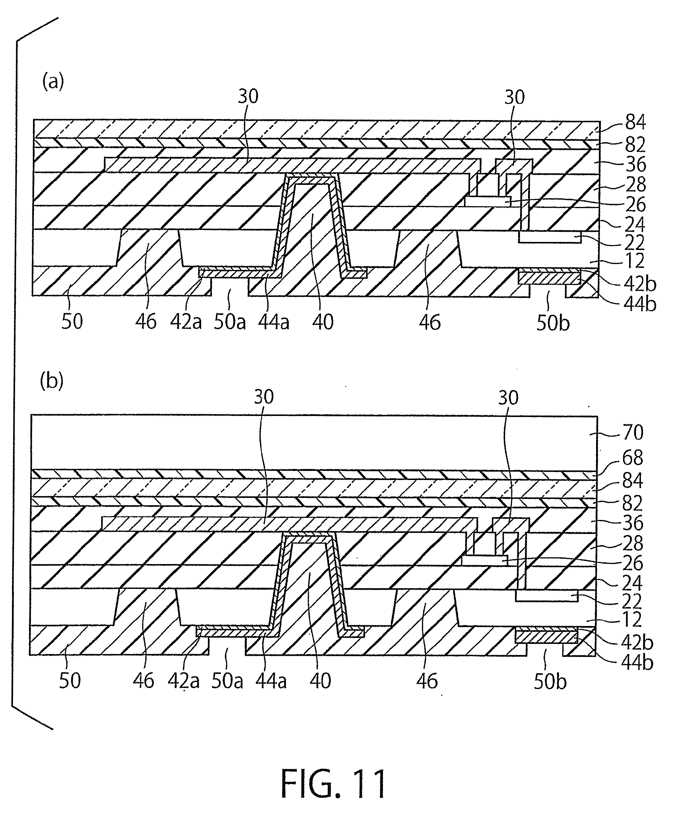

Referring now to Figs. 11(a) and 11(b), a method of manufacturing the radiation detector 10D of the third embodiment is described. Prior to and in the step shown in Fig. 8(a), the radiation detector 10D is manufactured in the same manner as in the first embodiment. Although the support glass 84 is detached from the semiconductor substrate 12 in the first embodiment, the support glass 84 is thinned (Fig. 11(a)) after the openings 50a and the openings 50b that lead to the TSV electrodes 44a and the bottom-surface electrodes 44b, respectively, are formed in the insulating film 50 made of resin (Fig. 8(a)). This thinning is performed by polishing and etching. The thickness of the support glass 84 is reduced from 500 µm to a thickness between 50 µm and 150 µm, for example.

Lastly, as shown in Fig. 11(b), the scintillator 70 is bonded to the thinned support glass 84 with the adhesive agent 68. As a result, the radiation detector 10D shown in Fig. 10 is completed. The scintillator 70 may be made of a material such as LGSO ((Lu,Gd)₂SiO₅) or LYSO (Cerium doped Lutetium Yttrium Orthosilicate). Each of the adhesive agents 68 and 82 needs to have such a degree of transparency as to transmit visible light generated from the scintillator 70. The thicknesses of the adhesive agents 68 and 82 are approximately 10 µm to 100 µm.

The third embodiment can also achieve the same effects as those of the first embodiment. Furthermore, having the support glass 84, the radiation detector 10D of the third embodiment has a higher strength than that of the radiation detector 10 of the first embodiment. Accordingly, breakage can be more effectively prevented when the radiation detector is handled.

As described so far, according to the first through third embodiments and the modifications thereof, isolation trenches penetrating through the semiconductor substrate are formed so as to surround the TSVs. Accordingly, the breakdown voltage of the TSV insulating film (the breakdown voltage between the TSV electrodes and the bottom-surface electrodes) can be dramatically improved.

Also, as the through holes and the isolation trenches in the TSV electrode portions are filled integrally with insulating resin, wafer breakage can be prevented by virtue of the mechanical strength and the appropriate elastic effect of the resin when the thinned Si substrate is handled. If the isolation trenches are made wider to improve processability of the isolation trenches, the isolation trenches can be easily filled with insulating resin. Accordingly, the isolation trenches can be easily processed. Furthermore, as the insulating resin to fill the through holes and the isolation trenches is integrally formed, the manufacturing process can be simplified, and the manufacturing costs can be lowered.

The first modification or the second modification of the first embodiment may be applied to the radiation detector of the third embodiment. Also, the third embodiment may be applied to the second embodiment.

### (Fourth Embodiment)

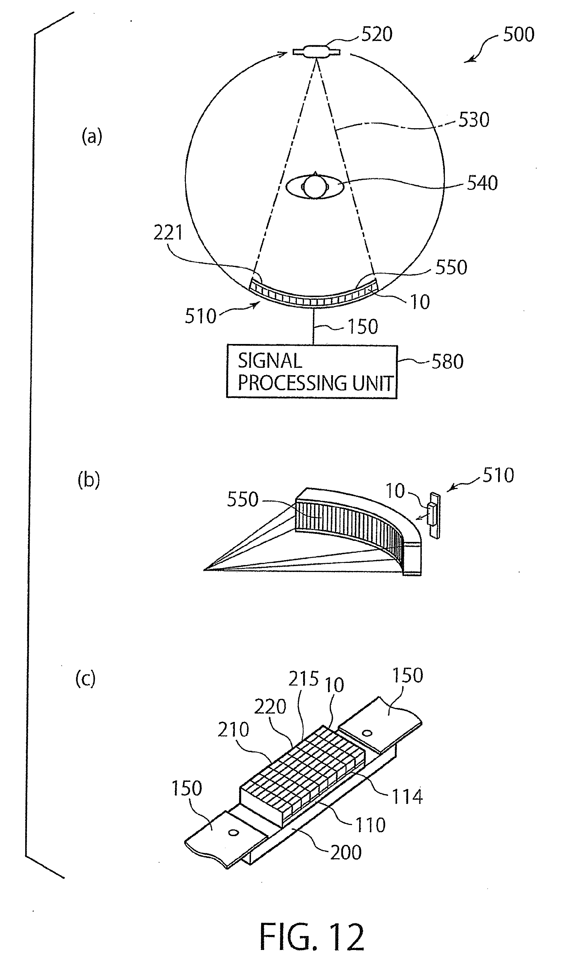

Referring to Figs. 12(a) through 12(c), the structure of a radiation detection apparatus according to a fourth embodiment is described. Fig. 12(a) is a cross-sectional view of the structure of the radiation detection apparatus 500 of the fourth embodiment.

As shown in Fig. 12(a), the radiation detection apparatus 500 includes a radiation tube 520, radiation detecting units 510 placed on the opposite side from the radiation tube 520, and a signal processing unit 580.

The radiation tube 520 is a device that emits a radiation beam 530 such as an X-ray in a fan-like shape toward the radiation detecting units 510 located on the opposite side. The radiation beam 530 emitted from the radiation tube 520 passes through a test subject 540 on a stand (not shown), and enters the radiation detecting units 510.

Each of the radiation detecting units 510 is a device that has an incident surface 221 to receive the radiation beam 530 that has been emitted from the radiation tube 520 and partially passed through the test subject 540, converts the radiation into visible light, and detects the visible light as an electrical signal. The radiation detection apparatus 500 includes the radiation detecting units 510 arranged in an arc-like shape, a collimator 550 placed on the side of the incident surfaces 221 of the radiation detecting units 510, and the signal processing unit 580 connected, by signal lines 150, to electrodes on the opposite side of the respective radiation detecting units 510 from the radiation tube 520.

The radiation detecting units 510 convert the radiation (the radiation beam 530) entering from the incident surfaces 221 into visible light, and converts (photoelectrically converts) the visible light into electrical signals (currents) with photoelectric conversion elements 114 described later.

The collimator 550 is an optical system that is placed on the side of the incident surfaces 221 of the radiation detecting units 510, and refracts radiation so as to enter the radiation detecting units 550 in a collimated manner.

The signal processing unit 580 receives the electrical signals (currents) photoelectrically converted by the respective radiation detecting units 510 via the signal lines 150, and calculates, from the current values, the energy of the radiation that has entered the respective radiation detecting units 510. From the energy of the radiation that has entered the respective radiation detecting units 510, the signal processing unit 580 generates a radiation image that is colored in accordance with the substances in the test subject 540.

The radiation tube 520 and the radiation detecting units 510 are designed to rotate about the test subject 540. With this arrangement, the radiation detection apparatus 500 can generate a cross-sectional image of the test subject 540.

The radiation detection apparatus 500 according to this embodiment can be used not only for generating cross-sectional images of human bodies, animals, or plants, but also as an inspection apparatus such as a security screening apparatus for fluoroscopically inspecting objects.

Referring now to Figs. 12(b) and 12(c), the radiation detecting units 510 and the structure thereof are described. Fig. 12(b) shows the arrangement of the radiation detecting units 510 arranged in an arc-like shape. Fig. 12(c) schematically shows the structure of the radiation detector 10 of one radio detecting unit 510.

As shown in Fig. 12(b), the radiation detecting units 510 are arranged in an arc-like shape, and the collimator 550 is placed on the radiation incident surface sides. As shown in Fig. 12(c), in a radiation detecting unit 510, a radiation detector 10 is secured onto a device supporting panel 200. The radiation detector 10 includes a photoelectric conversion layer 110 having photoelectric conversion elements 114 arranged therein, and a scintillator 210 that converts radiation into scintillation light. The photoelectric conversion layer 110 and the scintillator 210 form a stack structure, with the incident surface side of the photoelectric conversion layer 110 being bonded to the emission surface side of the scintillator 210 with an adhesive layer.

The scintillator 210 includes light reflection layers 215 that are formed at predetermined pitch in two directions perpendicular to each other. The photoelectric conversion layer 110 and the scintillator 210 are divided, by the light reflection layers 215, into photoelectric conversion components 220 arranged in a matrix form. The photoelectric conversion components 220 include photoelectric conversion elements 114, and energy of incident radiation is detected by each photoelectric conversion component 220.

In the radiation detection apparatus 500 shown in Figs. 12(a) through 12(c), the radiation detectors 510 are radiation detectors according to one of the first through third embodiments and the modifications thereof. The photoelectric conversion elements 114 are equivalent to the pixels 20 described in the first through third embodiments.

According to the fourth embodiment, a radiation detection apparatus that includes radiation detectors capable of improving the breakdown voltage of the TSV insulating films can be obtained.

The radiation detectors of the first through third embodiments and the modifications thereof, and the radiation detection apparatus of the fourth embodiment can be used not only for obtaining cross-sectional images of human bodies, animals, or plants, but also in various kinds of inspection apparatuses such as security screening apparatuses for fluoroscopically inspecting objects.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A radiation detector comprising:
a semiconductor substrate having a first surface and a second surface located on the opposite side from the first surface;
a light detecting unit provided on a side of the first surface of the semiconductor substrate;
a first insulating film provided on the first surface to cover the light detecting unit;
a second insulating film covering the first insulating film;
a scintillator provided on the second insulating film, and converting radiation into visible light;
a first opening penetrating through the semiconductor substrate and the first insulating film;
an interconnection provided between the first insulating film and the second insulating film, and connected to the light detecting unit;
a first electrode connected to the interconnection through a bottom portion of the first opening, the first electrode being provided on a bottom surface and a side surface of the first opening and on part of the second surface;
a second electrode provided on a region in the second surface of the semiconductor substrate, the region opposing at least a part of the light detecting unit;
a second opening provided in the semiconductor substrate, the second opening being located in a region, the region surrounding the first electrode and not surrounding the second electrode; and
an insulating resin layer covering the first electrode, the second electrode, the first opening, and the second opening, the insulating resin layer having a third opening and a fourth opening provided therein, the third opening leading to the first electrode, the fourth opening leading to the second electrode.

2. The detector according to claim 1, wherein the second opening also penetrates through the first insulating film, and leads to the interconnection.

3. The detector according to claim 1, further comprising
a metal seed layer provided between the first electrode and the bottom and side surfaces of the first opening.

4. The detector according to claim 1, further comprising
a third insulating film provided between the first electrode and the bottom and side surfaces of the first opening,
wherein
a hole leading to the interconnection is provided in a portion of the third insulating film, the portion corresponding to a bottom portion of the first opening, and
the first electrode is connected to the interconnection through the hole.

5. The detector according to claim 4, further comprising
a metal seed layer provided between the third insulating film and the first electrode.

6. The detector according to claim 1, further comprising
an insulating layer made of silicon nitride, the insulating layer being provided on regions of the second insulating film, the regions corresponding to the first opening and the second opening.

7. The detector according to claim 1, wherein the scintillator and the second insulating film are bonded with an adhesive agent.

8. The detector according to claim 1, comprising
a plurality of pixels arranged in a matrix form on the semiconductor substrate,
wherein
each of the pixels includes a plurality of cells, the first electrode, the second electrode, and the interconnection,
each of the cells includes the light detecting unit, and
in each of the pixels, the cells are connected in parallel to the interconnection.

9. The detector according to claim 1, wherein the light detecting unit includes an avalanche photodiode.

10. A radiation detection apparatus comprising:
the radiation detector of claim 1;
a radiation tube that emits radiation to the radiation detector via an object, the radiation tube being provided on the opposite side from the radiation detector; and
a signal processing unit that processes a signal output from the radiation detector.

11. The apparatus according to claim 10, wherein the second opening also penetrates through the first insulating film, and leads to the interconnection.

12. The apparatus according to claim 10, further comprising
a metal seed layer provided between the first electrode and the bottom and side surfaces of the first opening.

13. The apparatus according to claim 10, further comprising
a third insulating film provided between the first electrode and the bottom and side surfaces of the first opening,
wherein
a hole leading to the interconnection is provided in a portion of the third insulating film, the portion corresponding to a bottom portion of the first opening, and
the first electrode is connected to the interconnection through the hole.

14. The apparatus according to claim 13, further comprising
a metal seed layer provided between the third insulating film and the first electrode.

15. The apparatus according to claim 10, further comprising
an insulating layer made of silicon nitride, the insulating layer being provided on regions of the second insulating film, the regions corresponding to the first opening and the second opening.

16. The apparatus according to claim 10, wherein the scintillator and the second insulating film are bonded with an adhesive agent.

17. The apparatus according to claim 10, comprising
a plurality of pixels arranged in a matrix form on the semiconductor substrate,
wherein
each of the pixels includes a plurality of cells, the first electrode, the second electrode, and the interconnection,
each of the cells includes the light detecting unit, and
in each of the pixels, the cells are connected in parallel to the interconnection.

18. The apparatus according to claim 10, wherein the light detecting unit includes an avalanche photodiode.
